Europäisches Patentamt
European Patent Office
Office européen des brevets

Publication number: **0 287 019 A2**

# EUROPEAN PATENT APPLICATION

Application number: **88105754.1**

Date of filing: **12.04.88**

Int. Cl.4 **C08F 267/06 , C08F 2/46 , C08F 8/14 , C08F 299/00**

Priority: **16.04.87 US 39034**

Date of publication of application: **19.10.88 Bulletin 88/42**

Designated Contracting States: **AT BE CH DE ES FR GB GR IT LI LU NL SE**

Applicant: **W.R. GRACE & CO.**
**Grace Plaza 1114 Avenue of the Americas**
**New York New York 10036(US)**

Inventor: **Browne, Alan Robert**
**9464 Hundred Drums Row**
**Columbia, Md. 21046(US)**
Inventor: **Kyle, David Ray**
**9421 Granit Hill Road**
**Columbia, Md. 21046(US)**
Inventor: **Morgan, Charles Robert**
**19108 Holberton Lane**
**Brookeville, Md. 20833(US)**

Representative: **UEXKÜLL & STOLBERG**
**Patentanwälte**
**Beselerstrasse 4**
**D-2000 Hamburg 52(DE)**

## Aqueous developable, radiation curable composition.

An aqueous developable, radiation curable composition comprising

(1) a carboxylic acid containing reaction product of a styrene-maleic anhydride copolymer and a hydroxy (meth)acrylate of the formula:

$$HO-(R)-O\overset{\overset{O}{\|}}{C}\underset{R_1}{C}=CH_2$$

wherein R is alkyl, alkyl ester or alkyl ether containing 2-20 carbon atoms and $R_1$ is H or $CH_3$, the mole ratio of the hydroxy (meth)acrylate to the anhydride in the styrene-maleic anhydride copolymer being in the range 0.8 - 1.0;

(2) an ethylenically unsaturated, reactive diluent of the formula:

$$(CH_2=\underset{R_2}{C}-\overset{\overset{O}{\|}}{C}-O-)_n-R_3$$

EP 0 287 019 A2

wherein $R_2$ is H or $CH_3$, $R_3$ is an organic moiety and n is 1 or more; and, optionally,

(3) a photoinitiator for (1) and (2).

The exposure of the composition optionally also with a thiol to UV or high energy ionizing radiation results in aqueous, developable printing plates and photoresists.

# AQUEOUS DEVELOPABLE, RADIATION CURABLE COMPOSITIONS

## BACKGROUND OF THE INVENTION

### 1. Field of the Invention

This invention relates to a radiation curable composition and the use of this composition alone and in conjunction with other materials as a photoresist. More particularly, this invention relates to a radiation curable composition that is useful in making printed circuit boards by etching or plating processes. The radiation curable composition is aqueous developable. By "aqueous developable" herein is meant that the developer is water based and does not contain any organic solvents.

### 2. Description of the Prior Art

U.S. 4.370.403 teaches a photopolymerizable composition comprising a styrene-maleic anhydride copolymer in conjunction with (a) 2-hydroxyethyl acrylate, (b) additional ethylenic compounds and (c) a photoinitiator.

U.S. 4.415.651 teaches a monomer-free photosensitive composition comprising (a) a polyene having a number average molecular weight of about 1.000 to 1.000.000, (b) a reactive mercapto acid and (c) a radiationsensitive, radical-generating system activatable by actinic radiation to initiate addition of the mercapto acid to the polyene.

U S. 4.104.241 teaches a composition of matter comprising (a) a thermosetting internally unsaturated polyester resin and (b) an adduct of (1) a polymer formed from a liquid monomer selected from the group consisting of styrene, substituted styrenes, lower alkyl esters of acrylic and methacrylic acids, cyclic acrylates and diallyl phthalate and an unsaturated dicarboxylic acid selected from the group consisting of maleic anhydride, fumaric acid, citraconic acid, itaconic acid and chloromaleic acid and (2) a hydroxy-alkyl unsaturated monomer having the formula:

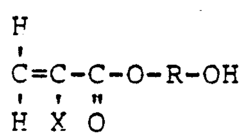

wherein X is hydrogen or methyl and R is an alkyl group containing from 1 to 10 carbon atoms and wherein said adduct is capable of polymerizing with the thermosetting unsaturated polyester.

U.S. 4.401.793 teaches an anaerobic composition comprising (a) about 5-95% by weight of a polymerizable, anaerobically curable $C_2$-$C_5$ hydroxyalkyl acrylate or methacrylate monomer, (b) about 5-95% by weight of a polymerizab1e polymeric adduct having pendant double bonds as a reactive thickener: the adduct being the addition reaction product of the $C_2$-$C_5$ hydroxyalkyl acrylate or methacrylate monomer of (a) and an anhydride-containing polymer derived from about 0.5-50 mole percent maleic, citraconic or itaconic anhydride and about 50-99.5 mole percent of a monomer having the formula $CH_2=C(R')X$, wherein R' is H, $CH_3$ or CN, X is a phenyl or COOR group and R is a halogen substituted or unsubstituted $C_1$-$C_{12}$ alkyl group or a halogen, alkoxy or ester substituted or unsubstituted $C_7$-$C_{20}$ aralkyl group, the adduct being free of unreacted anhydride groups, (c) 0-15% by weight of a carboxyl-containing monomer and (d) a free radical inhibitor in sufficient concentration to initiate cure upon the exclusion of oxygen.

U.S. 4,008,341 teaches a composition curable in the presence of a free radical generating agent comprising (a) 98 to 2% by weight of the composition of a liquid polyene component of the formula $[A]-(X)_m$ wherein m is an integer of at least 2, X is:

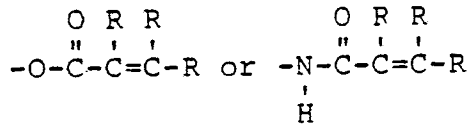

and A is a polyvalent organic moiety, free of reactive carbon-to-carbon unsaturation and of highly water-sensitive members and consisting of atoms selected from the group consisting of carbon, hydrogen, oxygen, nitrogen, chlorine, bromine, fluorine, phosphorous and silicon; and R is a radical selected from the group consisting of hydrogen, phenyl and an alkyl containing 1 to 9 carbon atoms, and (b) 2 to 98% by weight of the composition of a polythiol having a molecular weight in the range from about 94 to 20,000 of the general formula $R_8\text{-}(SH)_n$ wherein $R_8$ is a polyvalent organic moiety and n is at least 2, the reactive unsaturated carbon-to-carbon bonds per molecule in the polyene and the thiol groups per molecule in the polythiol being greater than 4 and up to about 50% by weight of the polyere/polythiol composition of a photocuring rate accelerator.

In making a printed circuit board by dry film photoresist methods, a solid photosensitive material is adhered to the printed circuit board blank. An image bearing negative of the desired circuit is placed on this photosensitive material and the photosensitive material exposed to light. The light, on striking certain areas of the photosensitive material, changes it so that the material which has not been exposed to the light and that which has been exposed exhibit differing characteristics, such as solubility. The unexpected photosenstive material is then usually removed from the circuit board blank. There are then left areas coated with a solid polymer and areas uncoated. The uncoated areas can be coated with solder, electroplated or the underlying conductive material can be removed. The solid polymer remaining on the circuit board is then usually removed in a subsequent step.

The usual wet photoresist methods for making printed circuit boards consist of coating a liquid polymer composition onto the circuit board blank and then exposing the blank imagewise to radiation sufficient to cure and solidify the exposed polymer. The cured polymer is then available to protect the underlying metal layer during one or more of the subsequent processing steps.

The essence of photoresist processes is the use of a material which after exposure to light can be removed from certain parts of the circuit board blank, but not from other areas. The material must also be capable of sharp resolution, i.e., it must be a material where the exposed areas and the unexposed areas are clearly and sharply defined. In order to get this sharp definition, those in the prior art have previously used solid photosensitive compositions and in the instances where a liquid was coated onto a circuit board blank, it was dried before any imaging. One reason for using a solid or a dried material was that it was felt that the image of the desired circuit had to be in direct contact with the photoresist in order to get sharp definition in the final circuit. However, this has been found not to be the case. It is possible to have an air gap between the negative or other image of the circuit and the photoresist and still produce printed circuits with sharp definition. This discovery has led to the feasible use of liquid polymers as photoresists.

## OBJECTS OF THE INVENTION

One object of the invention is to prepare a radiation curable composition. Another object of the invention is to prepare a radiation curable composition which is liquid and which can be used as a photoresist. Still another object of the invention is to prepare a radiation curable composition which after exposure imagewise to UV or high energy ionizing radiation is aqueous-developable. These and other objects will become apparent from a reading hereinafter.

These and other objects are obtained from an aqueous developable, radiation curable composition comprising

(1) the carboxylic acid containing reaction product of a styrene-maleic anhydride copolymer and a hydroxy (meth)acrylate of the formula:

$$HO-(R)-O\overset{\overset{O}{\|}}{C}\underset{\underset{R_1}{|}}{C}=CH_2$$

wherein R is alkyl, alkyl ester or alkyl ether containing 2-20 carbon atoms and $R_1$ is H or $CH_3$, the mole ratio of the hydroxy (meth)acrylate to the anhydride in the styrene-maleic anhydride copolymer being in the range 0.8 - 1 0.

(2) an ethylenically unsaturated, reactive diluent of the formula:

$$(CH_2=\underset{\underset{R_2}{|}}{C}-\overset{\overset{O}{\|}}{C}-O-)_n-R_3$$

wherein $R_2$ is H or $CH_3$, $R_3$ is an organic moiety and n is 1 or more; and, optionally,

(3) a photoinitiator.

The exposure of the composition optionally also with a thiol to UV or high energy ionizing radiation results in aqueous, developable printing plates, photoresists and the like.

Component (1), of the composition is the reaction product of a styrene-maleic anhydride copolymer and a hydroxy (meth)acrylate of the formula:

$$HO-(R)-O\overset{\overset{O}{\|}}{C}\underset{\underset{R_1}{|}}{C}=CH_2$$

wherein R is alkyl, alkyl ester or alkyl ether containing 2-20 carbon atoms and $R_1$ is H or $CH_3$, the mole ratio of the hydroxy (meth)acrylate to the anhydride in the styrene-maleic anhydride copolymer being in the range 0.8 - 1.0.

Styrene-maleic anhydride copolymeric resins are widely used in many applications such as paints, sizing agents for textiles, aqueous printing inks and the like. These resins are commercially available, e.g., from ARCO Chemical Co. under the tradename "SMA Resin", and from Monsanto Chemical Co. under the tradename "SCRIPSET Resin", respectively. The styrene-maleic anhydride copolymeric resins generally have a mo1ecular weight of from 700 to 250,000. The styrene-maleic anhydride copolymeric resins useful in the present invention have a molecular weight of from 1,000 to 3,000 and have a 3:1 to 1:1 mole ratio of styrene to maleic anhydride.

These styrene-maleic anhydride copolymers are reacted with a hydroxy (meth)acrylate of the formula:

$$HO-(R)-O\overset{\overset{O}{\|}}{C}\underset{\underset{R_1}{|}}{C}=CH_2$$

wherein R is alkyl, alkyl ester or alkyl ether containing 2 - 20 carbon atoms and $R_1$ is H or $CH_3$, the mole ratio of the hydroxy (meth)acrylate to the anhydride in the styrene-maleic anhydride copolymer being in the range 0.8 - 1.0.

In forming the reaction product of the styrene-maleic anhydride copolymer and the hydroxy (meth)-acrylate, the reaction is usuallv carried out in the presence of a diluent such as component (2) of the radiation curable composition of the instant invention. Various hydroxy (meth)acrylates are operable heren

to form component (1) and include, but are not limited to, hydroxyethyl acrylate, hydroxypropyl acrylate, hydroxybutyl acrylate, hydroxyethyl methacrylate, hydroxypropyl methacrylate, hydroxybutyl methacrylate, polyethylene glycol acrylate, polyethylene glycol methacrylate, polypropylene glycol acrylate, polypropylene glycol methacrylate and the reaction product of a mono(meth)acrylate derivative of a captolactone diol. The reaction is usually carried out with stirring at a temperature of 20 to 130°C for periods ranging from 0.1 to 48 hours.

Component (2) in the composition, i.e., the ethylenically unsaturated (meth)acrylate of the formula:

$$(CH_2{=}\overset{R_2}{\overset{|}{C}}-\underset{O}{\underset{\|}{C}}-O)_n-R_3$$

wherein $R_2$ is H or $CH_3$, $R_3$ is an organic moiety and n is 1 or more, acts as a reactive diluent. Such reactive diluents include, but are not limited to, trimethylolpropane triacrylate, hexanediol diacrylate, 1,3-butylene glycol diacrylate, diethylene glycol diacrylate, 1,6-hexanediol diacrylate, neopentyl glycol diacrylate, polyethylene glycol-200 diacrylate, tetraethylene glycol diacrylate, triethylene glycol diacrylate, pentaerythritol tetraacrylate, tripropylene glycol diacrylate, ethoxylated bisphenol-A diacrylate, di-trimethylolpropane tetraacrylate, triacrylate of tris(hydroxyethyl) isocyanurate, dipentaerythritol hydroxypentaacrylate, pentaerythritol triacrylate, ethoxylated trimethylolpropane triacrylate, triethylene glycol dimethacrylate, ethylene glycol dimethacrylate, tetraethylene glycol dimethacrylate, polyethylene glycol-200 dimethacrylate, 1,6-hexanediol dimethacrylate, neopentyl glycol dimethacrylate, polyethylene glycol-600 dimethacrylate, 1,3-butylene glycol dimethacrylate, ethoxylated bisphenol-A dimethacrylate, trimethylolpropane trimethacrylate, diethylene glycol dimethacrylate, 1,4-butanediol diacrylate, pentaerythritol tetramethacrylate, glycerin dimethacrylate, trimethylolpropane dimethacrylate, pentaerythritol trimethacrylate, pentaerythritol dimethacrylate, pentaerythritol diacrylate, isobornyl acrylate, isobornyl methacrylate, ethyl acrylate, ethoxyethoxyethyl acrylate, tetrahydrofurfuryl methacrylate, cyclohexyl methacrylate and the like which can be added to the composition to modify the cured product.

Also included as component (2) are carboxyl containing (meth)acrylates of the formula:

$$(CH_2{=}\underset{R_5}{\underset{|}{C}}-\overset{O}{\overset{\|}{C}}-O)_n-R_4-(COOH)_m$$

wherein $R_4$ is an organic moiety and $R_5$ is H or $CH_3$ and n and m are each 1 or more. These carboxyl containing materials are difunctional in that they not only act as a reactive diluent but also aid in water developability due to the presence of the carboxyl group. Examples of such material include, but are not limited to, hydroxy (meth)acrylate adducts of phthalic anhydride, maleic anhydride, trimellitic anhydride, pyromellitic anhydride, benzophenone tetracarboxylic acid dianhydride and the like.

To the resulting reaction product in a diluent comprising component (2) of the composition is added a photoinitiator, i.e., component (3) when UV radiation is used for curing. Preferred photoinitiators are carbonyl compounds having at least one aromatic nucleus attached directly to the carbonyl group. Various photoinitiators include, but are not limited to, benzophenone, acetophenone, o-methoxybenzophenone, acenapthene-quinone, methyl ethyl ketone, valerophenone, hexanophenone, alpha-phenylbutyrophenone, p-morpholinopropiophenone, dibenzosuberone, 4-morpholinobenzophenone, 4'-morpholinodeoxybenzoin, p-diacetylbenzene, 4-aminobenzophenone, 4'-methoxyacetophenone, benzaldehyde, alpha-tetralone, 9-acetylphenanthrene, 2-acetylphenanthrene, 10-thioxanthenone, 3-acetylphenanthrene, 3-acetylindone, 9-fluorenone, 1,3,5-triacetylbenzene, xanthrene-9-one, 7-H-benz[de]anthracen-7-one, 1-naphthaldehyde, 4,4'-bis(dimethylamino)-benzophenone, fluorene-9-one, 1'-acetonaphthone, 2'-acetonaphthone, 2,3-butanedione, acetonaphthone, benz[a]anthracene7,12-dione, benzil, etc. Another class of photoinitiators is the benzoin alkyl ethers, such as benzoin methyl ether, benzoin ethyl ether, benzoin isopropyl ether and benzoin isobutyl ether. Still another class of photoinitiators are the dialkoxyacetophenones exemplified by 2,2-dimethoxy-2-phenylacetophenone and 2,2-diethoxy2-phenylacetophenone. Phosphine compounds such as triphenylphosphine and tri-o-tolylphosphine are also operable herein as photoinitiators. The photoinitiators or

mixtures thereof are usually added in an amount ranging from 0.01 to 10% by weight of the composition.

The composition can optionally contain a thiol, preferably a polythiol. The thiols react with the ethylenic unsaturation in components (1) and (2) to form thioethers. The polythiols, if added, are added in amounts ranging up to a stoichiometric amount necessary to react with all of the ethylenic unsaturation in the composition.

As used herein, the term "polythiols" refers to simple or complex organic compounds having a multiplicity of pendant or terminally positioned -SH functional groups per average molecule.

On the average the polythiols must contain 2 or more -SH groups molecule. Operable polythiols in the instant invention usually have molecular weights in the range about 94 to about 20,000 or more, preferably about 100 to about 10,000.

The polythiols operable in the instant invention can be exemplified by the general formula: $R_8$-$(SH)_n$ where n is at least 2 and $R_8$ is a polyvalent organic moiety free from "reactive" carbon-to-carbon unsaturation. Thus, $R_8$ may contain cyclic groupings and minor amounts of hetero atoms such as N, S, P or O but primarily contains carbonhydrogen, carbon-oxygen or silicon-oxygen containing chain linkages free of any "reactive" carbon-to-carbon unsaturation.

One class of polythiols operable with polyenes in the instant invention to obtain essentially odorless cured products are esters of thiol-containing acids of the general formula: HS-$R_9$-COOH where $R_9$ is an organic moiety containing no "reactive" carbon-to-carbon unsaturation with polyhydroxy compounds of the general structure: $R_{10}(OH)_n$ where $R_{10}$ is an organic moiety containing no "reactive" carbon-to-carbon unsaturation and n is 2 or greater. These components will react under suitable conditions to give a polythiol having the general structure:

$$R_{10}-(O\overset{O}{\overset{\|}{C}}-R_9-SH)_n$$

where $R_9$ and $R_{10}$ are organic moieties containing no "reactive" carbon-to-carbon unsaturation and n is 2 or greater.

Certain polythiols such as the aliphatic monomeric polythiols (ethane dithiol, hexamethylene, dithiol, decamethylene dithiol, tolylene-2,4-dithiol, etc.) and some polymeric polythiols such as a thiol-terminated ethylcyclohexyl dimercaptan polymer, etc., and similar polythiols which are conveniently and ordinarily synthesized on a commercial basis, although having obnoxious odors, are operable in this invention. Examples of the polythiol compounds preferred for this invention because of their relatively low odor level and fast curing rate include, but are not limited to, esters of thioglycolic acid ($HS$-$CH_2COOH$), alpha-mercaptopropionic acid ($HS$-$CH(CH_3)$-$COOH$ and beta-mercaptopropionic acid ($HS$-$CH_2CH_2COOH$) with polyhydroxy compounds such as glycols, triols, tetraols, pentaols, hexaols, etc. Specific examples of the preferred polythiols include, but are not limited to, ethylene glycol bis(thioglycolate), ethylene glycol bis-(beta-mercaptopropionate), trimethylolpropane tris(thioglycolate), trimethylolpropane tris(beta-mercaptopropionate), pentaerythritol tetrakis (thioglycolate) and pentaerythritol tetrakis (beta-mercaptopropionate), all of which are commercially available. A specific example of a preferred polymeric polythiol is polypropylene ether glycol bis(betamercaptopropionate) which is prepared from polypropyleneether glycol (e.g., Pluracol P2010, Wyandotte Chemical Corp.) and beta-mercaptopropionic acid by esterification.

One class of operable thiols are thioether-containing mercaptocarboxylic acids prepared by the free-radical induced reaction of the above cited polythiols wherein n is 2 or more with unsaturated acids such as acrylic, methacrylic, itaconic and maleic.

Another class of operable thiols are thiols such as 3-mercaptopropionic acid and mercaptoacetic acid. When monothiols are used, they are added in amounts up to 90% of the stoichiometric amount necessary to react with the ethylenic unsaturation in the composition.

In the instant invention component (1) is added in an amount ranging from 10 to 90% by weight of the composition. Component (2) may be added in an amount ranging from 1 to 90% by weight of the composition. Component (3), the photoinitiator, is added in an amount ranging from 0.1 to 10% by weight of the composition.

The compositions in accord with the present invention may, if desired, include such conventional additives as antioxidants, accelerators, dyes, inhibitors, activators, fillers, pigments, anti-static agents, flame-retardant agents, thickeners, thixotropic agents, surface-active agents, viscosity modifiers, exterding oils, plasticizers, tackifiers and the like within the scope of this invention. Such additives are usually blended into the composition during the compounding step. Operable fillers include natural and synthetic resins, carbon

black, glass fibers, wood flour, clay, silica, alumina, carbonates, oxides, hydroxides, silicates, glass flakes, glass beads, borates, phosphates, diatomaceous earth, talc, kaolin, barium sulfate, calcium sulfate, calcium carbonate, antimony oxide and the like. The aforesaid additives may be present in effective quantities up to 500 parts or more per 100 parts of the composition by weight and preferably about 0.0005 to about 300 parts on the same basis.

The preferred free radical generator for the curing reaction is actinic radiation, suitably in the wavelength of about 200 to 750 nanometers, preferably from 200 to 400 nanometers.

A class of actinic light useful herein is ultraviolet light and other forms of actinic radiation which are normally found in radiation emitted from the sun or from artificial sources such as Type RS Sunlamps, carbon arc lamps, xenon arc lamps, mercury vapor lamps, tungsten halide lamps and the like.

It is to be understood, however, that, when energy sources, e.g., ionizing radiation, other than visible or ultraviolet light, are used to initiate the curing reaction, photoinitiators generally are not recuired in the formulation.

The following examples will aid and explain, but expressly not limit, the instant invention. Unless otherwise noted, all parts and percentages are by weight.

Example 1

A mixture of 168.5 g SMA$^R$-1000A (styrene-maleic anhydride copolymer, commercially available from ARCO Chemical Co.), 133.32 g of Photomer-4158 (polyethoxylated trimethylolpropane triacrylate, commercially available from Diamond Shamrock), 94.96 g of Rocryl$^R$-400 (hydroxyethyl methacrylate, commercially available from Rohm & Haas Chemical Co.) and 0.4 g hydroquinone were charged into a 1 liter resin kettle equipped with a stirrer and thermometer. The mixture was agitated to form a slurry, then 2.8 g stannous octoate were added and the agitated mixture heated to 100°C. The reaction mixture was heated at 100-105°C for 6-7 hours and then allowed to cool to 85-90°C. The mixture was kept at 85-90°C overnight and then discharged into a glass jar. The resultant mixture will hereinafter be referred to as Oligomer Mixture I.

Example 2

A mixture of 75.0 g SMA$^R$-1000A (from ARCO Chemical Co.); 107.1 g Tone$^R$M-100 (hydroxycaprolactone acrylate, commercially available from Union Carbide Corp.); 20.4 g of Photomer-4072 (propoxylated trimethylolpropane triacrylate, commercially available from Diamond Shamrock); 0.2 g hydroquinone and 1.4 g stannous octoate were charged into a 500 ml resin kettle equipped with a stirrer and thermometer. The mixture was agitated to form a slurry and then heated to 100°C. The reaction mixture was heated at 100-105°C for 6-7 hours and then discharged into a glass jar. The resultant mixture will hereinafter be referred to as Oligomer Mixture II.

488 g of pentaerythritol tetrakis(beta-mercaptopropionate), 130 g of itaconic acid and 6.1 g of benzopinacol were charged to a 2,000 ml, 3-neck, round bottom flask containing 700 ml benzene and equipped with condenser, stirrer and thermometer. Heat was supplied by a heating mantle. The reaction mixture was refluxed at 83°C for 22 hours. After cooling, the benzene was removed and the resultant product:

$$(HSCH_2CH_2\overset{\overset{O}{\|}}{C}OCH_2)_3CCH_2O\overset{\overset{O}{\|}}{C}CH_2CH_2SCH_2\underset{}{\overset{\overset{COOH}{|}}{C}}HCH_2COOH$$

was confirmed by proton NMR.

Example 4

Formulation A

The following materials were mixed together at 80°C to make Formulation A:

| Material | Grams |
|---|---|
| Oligomer Mixture I (from Example 1) | 62.475 |
| Photomer-6173 (phthalic acid, hydroxyethyl acrylate monoether, from Diamond Shamrock) | 23.608 |
| p-Methoxyphenol (Aldrich) | 0.050 |
| Pyrogallol (Fisher) | 0.025 |
| Triiosooctyl phosphite (Mobil Chem.) | 0.458 |
| Phosphoric acid | 0.050 |
| Irgacure-651 (Ciba-Geigy) | 1.667 |
| Benzophenone (Aldrich) | 1.667 |
| Penn Blue-9S87 | 1.667 |
| Pentaerythritol tetrakis(beta-mercaptopropionate)/ itaconic acid adduct from Example 3 | 8.33 |

Formulation A (at 80°C) was drawn down to 2-3 mils of thickness using a zero drawdown bar. onto a double-sided, 1 oz. copper electroless plated laminate board with a 0.060 in. epoxy-glass core. The coated board was off contact (0.030 in. air gap) imaged through a phototool using an 8-second exposure from an Optical Radiation Corp., collimated UV lamp with an intensity of 13 milliwatts/$cm^2$. The imaged board was spray developed in a Chemcut developer unit containing an 0.7% aqueous sodium carbonate solution to remove the uncured formulation, leaving a cured image of a circuit. The board with the cured circuit image was placed in a 55°C, agitated etch solution consisting of 1,350 g cupric chloride; 1,080 ml hydrochloric acid and 4,000 ml of water for 400 seconds to remove all of the exposed copper and leaving the copper protected by the cured formulation. The etched board was rinsed in water, then placed in a 6.5% aqueous solution of sodium hydroxide for 30 seconds to fully strip the cured formulation, exposing the underlying circuit.

Example 5

Formulation B

The following materials were mixed together at 80°C to make Formulation B:

| Material | Grams |
|---|---|
| Oligomer Mixture II (from Example 2) | 36.65 |
| Photomer-6173 (phthalic acid, hydroxyethyl acrylate monoester, from Diamond Shamrock) | 5.00 |
| p-Methoxyphenol | 0.03 |
| Pyrogallol | 0.02 |
| Triisooctyl phosphite | 0.28 |
| Phosphoric acid | 0.03 |
| Irgacure-651 | 1.00 |
| Benzophenone | 1.00 |
| Penn Blue-9S87 | 1.00 |

Formulation B (at 80°C) was drawn down at 3-4 mils of thickness using a zero drawdown tar, onto a double-sided, 1 oz. copper, electroless plated laminate board with a 0.060 in. epoxy-glass core. The surface was covered with a clear polyester film, 0.001 in. thick. The coated board with the polyester cover film was contact imaged through a phototool using a 7-second exposure from an Optical Radiation Corp., collimated UV lamp with an intensity of 13 milliwatts.cm². The polyester cover film was removed from the imaged board and the board spray developed to remove uncured formulation in a Chemcut developer unit containing an 0.7% aqueous sodium carbonate solution. An image of a circuit formed from the cured formulation was left on the board. The copper was exposed where the uncured formulation was removed during development. The developed board with the circuit image was placed in an agitated 55°C etch solution as used in Example I, for 300 seconds to remove all the exposed copper and leaving the copper protected by the cured formulation. The etched board was rinsed in water, then placed in a 6.5% aqueous solution of sodium hydroxide at 60-64°C and shaken in the solution for 30 seconds to fully strip the cured formulation, exposing the underlying circuit.

## Claims

1. An aqueous developable, radiation curable composition consisting essentially of:

(1) a carboxylic acid containing reaction product of a styrene-maleic anhydride copolymer and a hydroxy (meth)acrylate of the formula:

$$HO-(R)-O\overset{O}{\overset{\|}{C}}\underset{R_1}{C}=CH_2$$

wherein R is alkyl, alkyl ester or alkyl ether containing 2-20 carbon atoms and $R_1$ is H or $CH_3$, the mole ratio of the hydroxy (meth)acrylate to the anhydride in the styrene-maleic anhydride copolymer being in the range 0.8 - 1.0;

(2) an ethylenically unsaturated, reactive diluent of the formula:

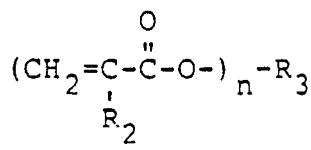

wherein $R_2$ is H or $CH_3$, $R_3$ is an organic moiety and n is 1 or more:

(3) a photoinitiator: and

(4) (a) a polyvthiol in an amount of up to the stoichiometric amount necessary to react with the ethylenic unsaturation in the composition, or

(b) a monothiol in an amount up to 90% of the stoichiometric amount necessary to react with the ethylenic unsaturation in the composition;

wherein component (1) is present in an amount ranging from 10 - 90%, component (2) is present in an amount ranging from 1 to 90%, and component (3) is present in an amount ranging from 0.01 to 10% by weight of the composition.

2. A process for forming a photoresist on a substrate which comprises

(A) applying to the surface of the substrate a layer of an aqueous developable, radiation curable composition comprising

(1) a carboxylic acid containing reaction product of a styrene-maleic anhydride copolymer and a hydroxy (meth)acrylate of the formula:

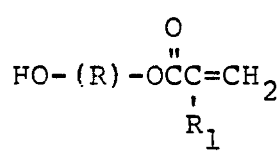

wherein R is alkyl, alkyl ester or alkyl ether containing 2-20 carbon atoms and $R_1$ is H or $CH_3$, the mole ratio of the hydroxy (meth)acrylate to the anhydride in the styrene-maleic anhydride copolymer being in the range 0.8 - 1.0;

(2) an ethylenically unsaturated, reactive diluent of the formula:

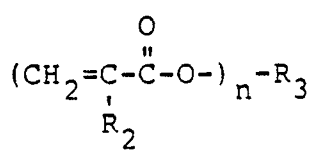

wherein $R_2$ is H or $CH_3$, $R_3$ is an organic moiety and n is 1 or more: and

(3) a photoinitiator,

(B) imagewise exposing selected areas of said composition to actinic radiation thereby curing the exposed areas of said composition, and

(C) removing the unexposed uncured areas of the composition with an aqueous developer.

6. The process according to Claim 5 wherein the surface of the substrate is copper.

3. A process for forming a printed circuit board which comprises

(A) applying to a metallic surface of a circuit board blank a layer of an aqueous developable, radiation curable composition comprising

(1) a carboxylic acid containing reaction product of a styrene-maleic anhydride copolymer and a hydroxy (meth)acrylate of the formula:

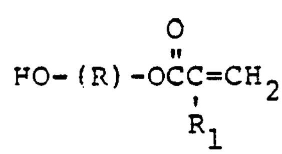

wherein R is alkyl, alkyl ester or alkyl ether containing 2-20 carbon atoms and $R_1$ is H or $CH_3$, the mole

ratio of the hydroxy (meth)acrylate to the anhydride in the styrene-maleic anhydride copolymer being in the range 0.8 - 1.0:

(2) an ethylenically unsaturated. reactive diluent of the formula:

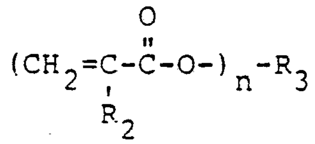

wherein $R_2$ is H or $CH_3$. $R_3$ is an organic moiety and n is 1 or more; and

(3) a photoinitiator.

(B) imagewise exposing selected areas of said composition to actinic radiation thereby curing and forming a photoresist of the exposed areas of said composition,

(C) removing the unexposed uncured areas of the composition with an aqueous developer thereby exposing the metallic surface there beneath,

(D) etching away said exposed metallic surface,

(E) removing the photoresist therebv exposing the printed circuit.

4. A process for forming a printed circuit board which comprises

(A) applying to a metallic surface of a circuit board blank a layer of an aqueous developable, radiation curable composition comprising

(1) a carboxylic acid containing reaction product of a stvrene-maleic anhydride copolymer and a hydroxy (meth)acrylate of the formula:

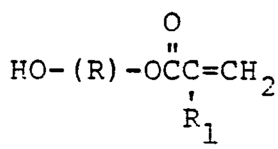

wherein R is alkyl, alkyl ester or alkyl ether containing 2-20 carbon atoms and $R_1$ is H or $CH_3$, the mole ratio of the hydroxy (meth)acrylate to the anhydride in the styrene-maleic anhydride copolymer being in the range 0.8 - 1.0:

(2) an ethylenically unsaturated, reactive diluent of the formula:

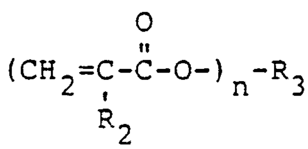

wherein $R_2$ is H or $CH_3$, $R_3$ is an organic moiety and n is 1 or more; and

(3) a photoinitiator,

(B) imagewise exposing selected areas of said composition to actinic radiation thereby curing and forming a photoresist of the exposed areas of said composition,

(C) removing the unexposed uncured areas of the composition with an aqueous developer thereby exposing the metal surface there beneath.

(D) plating a conductive metal on said exposed metal surface,

(E) removing the photoresist, and

(F) etching away the metal surface beneath the removed photoresist.

5. A process for forming a printed circuit board on a substrate which comprises

(A) applying to the surface of the substrate a layer of an aqueous developable, radiation curable composition comprising

(1) a carboxylic acid containing reaction product of a styrene-maleic anhydride copolymer and a hydroxy (meth)acrylate of the formula:

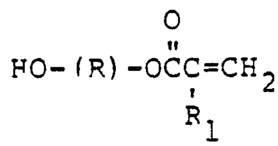

wherein R is alkyl, alkyl ester or alkyl ether containing 2-20 carbon atoms and $R_1$ is H or $CH_3$, the mole ratio of the hydroxy (meth)acrylate to the anhydride in the styrene-maleic anhydride copolymer being in the range 0.8 - 1.0:

(2) an ethylenically unsaturated, reactive diluent of the formula:

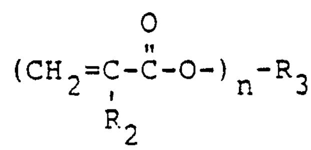

wherein $R_2$ is H or $CH_3$, $R_3$ is an organic moiety and n is 1 or more; and

(3) a photoinitiator,

(B) imagewise exposing selected areas of said composition to actinic radiation thereby curing and forming a photoresist of the exposed areas of said composition,

(C) removing the unexposed uncured areas of the composition with an aqueous developer thereby exposing the surface of the substrate, and

(D) plating a conductive metal on the exposed surface of the substrate.